# FASCICULE DE BREVET EUROPEEN

(11) **EP 0 418 148 B1**
(45) Date de publication et mention de la délivrance du brevet: **27.12.1995**
(21) Numéro de dépôt: 90402502.0
(22) Date de dépôt: 11.09.1990
(51) Int. Cl.: H05K 1/03, H01Q 21/00, H05K 3/46

(54) **Procédé de fabrication d'un support metallisé à base de polyméthylpentène**
Verfahren zur Herstellung eines metallisierten Trägers auf Basis von Polymethylpenten
Method of making a polymethylpentene based metallized support

(30) Priorité: 12.09.1989 FR 8911888
(43) Date de publication de la demande: 20.03.1991
(73) Titulaire: FRANCE TELECOM, 75015 Paris (FR)
(72) Inventeur: Demeure, Loic, F-22700 Perros Guirec (FR); Garnier, Yvonne, F-22300 Lannion (FR); Le Rouzic, Jean, F-22700 Perros Guirec (FR)
(74) Mandataire: Poulin, Gérard

(56) Documents cités:
- EP-A- 0 149 394
- EP-A- 0 262 931
- EP-A- 0 309 143
- GB-A- 1 186 218
- DATABASE DERWENT WPI, résumé no. 89-337619, Derwent Publications Ltd, Londres, GB; & JP-A-1 253 436

## Description

La présente invention concerne un procédé de fabrication d'un support métallisé. Elle s'applique notamment à la réalisation de circuits électroniques hyperfréquences et d'antennes planes (émettrices ou réceptrices) et même de cartes de crédit.

La réalisation de circuits électroniques hyperfréquences ou d'éléments rayonnants tels que les antennes planes nécessite l'utilisation de matériaux diélectriques répondant notamment aux conditions suivantes :
- constante diélectrique la plus faible possible,
- pertes diélectriques faibles,
- possibilité et facilité de métallisation par des métaux électriquement bons conducteurs, dont l'adhérence sur le diélectrique est bonne,
- coût le plus faible possible.

On connaît déjà, par la demande de brevet français n°83 21017 du 29 décembre 1983 et par la demande de brevet européen n° 84402 707.8 du 21 décembre 1984, des supports métallisés à base de polypropylène et un procédé de fabrication de ces supports.

Le polypropylène répond correctement aux conditions énumérées plus haut. Cependant, il présente l'inconvénient d'avoir une température de fusion de l'ordre de 150°C et donc de ne pas permettre la brasure de composants électroniques à l'aide d'un alliage classique, de type SnPb 63/37, couramment utilisée dans l'industrie électronique. En effet, cette technique de soudure nécessite que le matériau diélectrique supporte une température au moins égale à 200°C.

La présente invention a pour but de remédier à cet inconvénient en proposant un procédé de fabrication d'un support métallisé à base d'un matériau électriquement isolant, à savoir le poly(méthyl-4 pentène-1), dont la température de fusion est supérieure à 200°C.

La présente invention résout également le problème de la fabrication d'un support métallisé à base de poly(méthyl-4 pentène-1) en proposant un procédé de fabrication qui permet de revêtir le matériau isolant choisi de couches métalliques d'épaisseurs généralement supérieures à 5 micromètres, d'obtenir une bonne adhérence du métal sur ce matériau isolant et de réaliser des supports multicouches comportant éventuellement des couches métalliques internes gravées suivant des motifs déterminés.

On connaît, par EP-A-0309143, une plaque multicouche utilisable en tant que substrat de circuit électrique pour haute fréquence. Cette plaque comprend une couche de matière plastique renforcée et une couche conductrice fixée sur une face de la couche de matière plastique. Cette dernière comprend des fibres de renforcement, imprégnées d'une résine de polyméthyl pentène au moins partiellement modifié par greffage d'un acide carboxylique insaturé ou d'un dérivé de ce dernier.

On utilise donc, dans la présente invention, un matériau thermoplastique de type polyoléfine, à savoir le poly(méthyl-4 pentène-1), appelé plus simplement polyméthylpentène et noté PMP.

Le support obtenu par le procédé objet de la présente invention comporte une pluralité de couches de PMP (support de type multicouche).

Dans la présente invention, l'épaisseur d'une couche de PMP, qui a une fonction diélectrique, est importante : elle peut aller de quelques centaines de micromètres à plusieurs dizaines de millimètres.

L'épaisseur d'une couche métallique peut aller de quelques dizaines de micromètres à plusieurs millimètres.

Dans un support, ou circuit, multicouche obtenu conformément à l'invention, des couches de PMP alternent avec des couches métalliques, ces dernières étant gravées ou non et toutes les combinaisons d'épaisseurs entre isolants et conducteurs sont possibles, dans les limites des valeurs données ci-dessus.

Chaque couche métallique peut être faite d'un métal choisi de préférence dans le groupe comprenant le cuivre, les alliages de cuivre, l'aluminium et les alliages d'aluminium.

Le PMP peut être chargé d'au moins un matériau capable d'en modifier les caractéristiques mécaniques et/ou diélectriques.

La présente invention concerne un procédé de fabrication d'un support métallisé, conformément à la revendication 1.

Le placage à chaud des couches peut être un laminage à chaud ou un pressage à chaud.

Le procédé objet de l'invention peut comprendre en outre une étape de gravure de la couche métallique plaquée sur la couche de PMP.

Selon un mode de mise en oeuvre particulier du procédé objet de l'invention, le support obtenu comportant au moins une couche métallique externe, on fixe en outre, au moyen d'une couche d'adhésif, une autre couche métallique à cette couche métallique externe.

Le traitement de surface de chaque couche de PMP peut être choisi dans le groupe comprenant l'action d'une solution oxydante, le traitement à la flamme, le traitement par décharge couronne, l'irradiation par un rayonnement ultraviolet et le bombardement électronique.

Dans le cas où la couche métallique est en aluminium ou en un alliage d'aluminium, d'oxydation superficielle peut être une oxydation anodique sans colmatage.

Après réalisation du support, la face libre de chaque couche métallique externe de ce support peut être soumise à une désoxydation.

Enfin, la pression de placage est de préférence au moins égale à 10 kg/cm² environ, pour garantir une bonne adhérence des couches.

La présente invention sera mieux comprise à la lecture de la description suivante d'exemples de réalisation donnés à titre purement indicatif et nullement limitatif, en référence aux dessins annexés sur lesquels :
- la figure 1 est une vue en coupe schématique d'un support utilisable dans le procédé conformément à l'invention, comportant une couche de PMP dont une face est recouverte d'une couche métallique et dont l'autre face est partiellement recouverte d'une couche métallique faite du même métal que la précédente,
- la figure 2 est une vue en coupe schématique d'un support utilisable dans le procédé conformément à l'invention, comportant une couche de PMP dont une face est recouverte d'une couche faite d'un métal et dont l'autre face est partiellement recouverte d'une couche faite d'un autre métal,
- les figures 3 et 4 sont des vues en coupe schématiques de supports utilisable dans le procédé conformément à l'invention, comportant chacun un support du genre de celui de la figure 1 ainsi qu'une autre couche métallique reliée à l'une des deux couches de ce support du genre de celui de la figure 1, et
- la figure 5 est une vue en coupe schématique d'un support obtenu par le procédé conformément à l'invention, comportant des couches de PMP alternant avec des couches métalliques.

On commencera par indiquer les caractéristiques principales du PMP :
- constante diélectrique : 2,12,
- facteur de perte à 1GHz : 3,5.10⁻⁴,
- rigidité diélectrique : 63 à 65 kV/mm suivant le grade,
- densité : 0,83,
- température de fusion : 235°C à 240°C suivant le grade,
- bonne inertie chimique vis-à-vis des principaux acides et solvants.

On ajoutera que, par rapport au polytétrafluoroéthylène, le PMP est moins coûteux, ne nécessite pas d'adhésif spécifique pour réaliser des supports multicouches et a des conditions techniques de mise en oeuvre plus simples.

Par rapport au polypropylène, le PMP a, outre une meilleure tenue en température, une plus grande rigidité mécanique, ce qui est intéressant pour la fabrication de supports de grande surface (de l'ordre de 200 mm x 200 mm ou plus).

Pour réaliser des supports obtenu par le procédé conformément à la présente invention, on réalise un placage à chaud de feuilles (couches de faible épaisseur) ou de plaques (couches de forte épaisseur) métalliques sur du PMP sans utilisation d'un adhésif intermédiaire. Cette opération peut être faite par pressage ou par laminage, mais l'obtention d'une bonne adhérence, qualité indispensable pour les applications du procédé de l'invention, nécessite un traitement de surface préalable du PMP et du métal à y fixer.

Dans ce qui suit, on a pris l'exemple du pressage, réalisé à l'aide d'une presse à plateaux chauffants et refroidissants.

La technique de fabrication par laminage ne nécessite qu'une adaptation des paramètres de laminage (montée en température et pression, température, vitesse de laminage, notamment) au matériel de laminage utilisé.

On va maintenant expliquer comment réaliser un support stratifié utilisable dans le procédé conformément à l'invention, à une ou deux couches métalliques.

Il convient de préparer le PMP. Ce produit est disponible sous la forme de granulés, de plaques ou de feuilles. Dans tous les cas, il convient de réaliser, à partir du produit ainsi disponible, une plaque d'épaisseur légèrement supérieure (de 0,1 mm à 0,2mm) à celle que l'on veut obtenir une fois la métallisation terminée et dont l'épaisseur est supérieure à 100 micromètres.

Cette plaque est obtenue par pressage du PMP dans un drageoir ou dans un moule approprié.

Le cycle de travail est le suivant : on ferme la presse avec une pression de touche faible, de l'ordre de 0,2 kg/cm² ; on monte la température des plateaux de la presse jusqu'à 250°C ; lorsque cette température est atteinte, une pression de quelques kg/cm² est appliquée (par exemple de l'ordre de 10 kg/cm²) pendant un temps d'au moins 15 minutes ; ensuite, les plateaux de la presse sont refroidis lentement jusqu'à une température d'environ 50°C tout en maintenant la pression ; lorsque cette température d'environ 50°C est atteinte, la pression est ramenée à zéro ; alors, on procède à l'ouverture de la presse et au démoulage de la plaque de PMP ainsi obtenue.

Avant de procéder au placage du métal (en général du cuivre ou un alliage de cuivre ou de l'aluminium ou un alliage d'aluminium), il est nécessaire de faire subir à la plaque de PMP un traitement de surface destiné à ouvrir des chaînes moléculaires en surface, pour favoriser l'adhérence du métal.

Ce traitement de surface peut être réalisé de diverses manières : actions de solutions oxydantes, traitement à la flamme, traitement par décharge couronne, irradiation par un rayonnement ultraviolet, bombardement électronique notamment.

On utilise par exemple le traitement à la flamme. A cet effet, on passe dans la flamme oxydante d'un bec Bunsen la face de la plaque de PMP à métalliser, si l'on souhaite ne métalliser que cette face, ou les deux faces de cette plaque, si l'on souhaite métalliser ces deux faces. L'utilisation d'un bec Bunsen à buse aplatie permet de répartir la flamme sur toute la surface à traiter. L'opération est réalisée en quelques passes successives, sans amener le PMP à son point de fusion.

L'opération de flammage est à effectuer juste avant l'opération de pressage du métal sur le PMP car la durée de vie de son effet est limitée dans le temps, à environ une heure.

Le passage dans une décharge couronne, un rayonnement ultraviolet ou un plasma froid donne un effet plus durable, permettant un stockage temporaire de la plaque de PMP traitée, avant la métallisation de celle-ci.

On explique ci-après le traitement de surface du métal à plaquer sur la plaque de PMP.

Dans le cas du cuivre, pour une utilisation du support dans le domaine des circuits hyperfréquences, il est préférable d'utiliser une feuille de cuivre laminé plutôt que du cuivre électrolytique et, pour toute autre application, le choix du cuivre est également à optimiser.

Cependant, dans tous les cas, un traitement du cuivre est nécessaire pour obtenir une bonne adhérence de celui-ci sur le PMP.

Ce traitement consiste en une oxydation superficielle du cuivre, permettant la création de liaisons physiques et moléculaires avec le PMP.

Chaque couche (feuille ou plaque) de cuivre est d'abord dégraissée à l'aide de solvants puis éventuellement décapée par une méthode mécanique ou chimique. Ensuite, l'oxydation est par exemple obtenue par immersion de la couche pendant environ 15 minutes dans une solution aqueuse à une température de 95°C dont la composition est la suivante :
- chlorite de sodium NaClO₂ : 30 g/l,
- phosphate trisodique NaPO₄H₂O : 10 g/l,
- soude NaOH : 50 g/l,
- eau déminéralisée.

Après traitement dans cette solution, la couche présente un état de surface noir à l'aspect velouté mais non pulvérulent. Un bon séchage est nécessaire avant pressage sur le PMP.

Bien entendu, d'autres traitements aboutissant au même résultat peuvent être utilisés.

Dans le cas de l'aluminium, pour faire adhérer le PMP sur l'aluminium (ou un alliage de celui-ci), il est nécessaire de faire subir à l'aluminium ou à son alliage un traitement de surface favorisant l'adhérence.

Tout traitement de surface conduisant à ce résultat peut être pris en considération, mais le traitement le plus simple à mettre en oeuvre consiste à créer sur le métal (aluminium ou alliage de celui-ci) une couche d'alumine par oxydation anodique non suivie d'un colmatage, de sorte que les pores de la couche d'alumine restent ouverts.

L'épaisseur de la couche d'alumine peut être de l'ordre de 5 micromètres à 10 micromètres, mais toute autre épaisseur est envisageable en fonction de l'application visée.

Avant tout pressage du PMP sur la couche d'alumine, il est nécessaire que cette dernière soit soumise à un bon séchage.

Si l'on utilise une presse chauffante/refroidissante pour réaliser le support, l'opération de placage du métal sur le PMP s'effectue en introduisant entre les plateaux de la presse un outillage dans lequel ont été superposées la feuille de PMP traitée et la ou les plaques ou feuilles métalliques traitées.

Le cycle de pressage est alors identique au cycle de travail qui conduit à la plaque de PMP et qui a été décrit plus haut.

Ensuite, on sort l'outillage de pressage de la presse, on démoule le stratifié obtenu et l'on découpe les bords de celui-ci.

Si le métal utilisé est le cuivre, la face de ce dernier, qui n'est pas en contact avec le PMP, présente, après pressage, un aspect noir dû au traitement préalable que le cuivre a subi, à moins que seul un traitement de la face destinée à adhérer au PMP ait été effectué. Si l'on veut éliminer la couche d'oxyde noir se trouvant sur le cuivre, il suffit, par exemple, d'immerger le stratifié dans une solution d'acide chlorhydrique dilué à 30%.

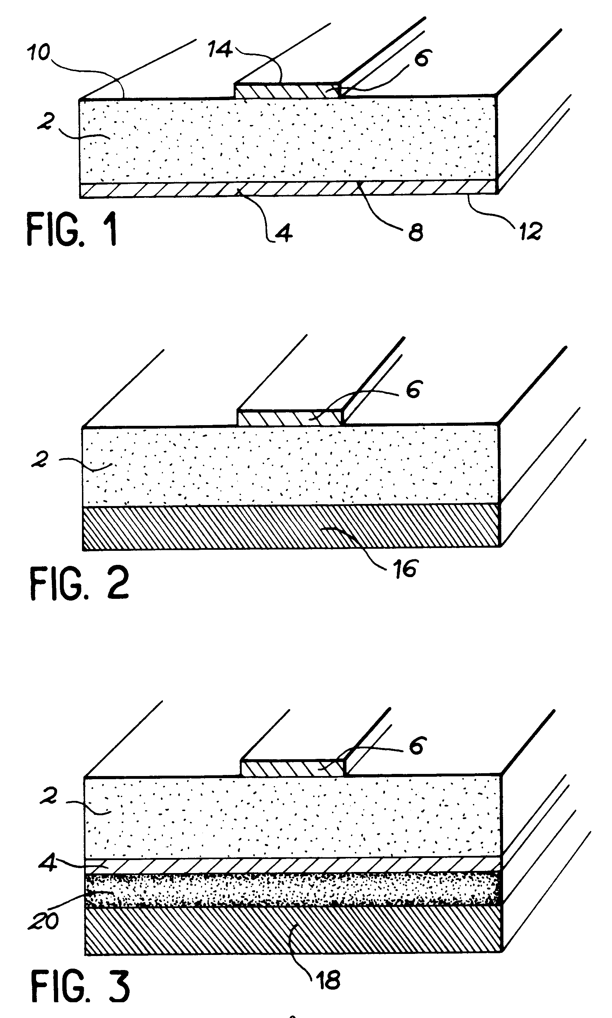

On voit sur la figure 1 un support réalisé par le procédé que l'on vient de décrire. Ce support comprend une couche 2 de PMP et deux couches métalliques 4 et 6, faites du même métal. La couche 4 recouvre totalement une face 8 de la couche 2 tandis que la couche 6 recouvre partiellement l'autre face 10 de cette couche 2.

Pour ce faire, il suffit de réaliser une couche métallique qui recouvre totalement la face 8 de la couche 10, puis de graver cette couche métallique de façon à obtenir la couche 6.

On notera que dans le cas de la figure 1, il a fallu traiter les faces 8 et 10 de la couche 2. Le traitement d'une seule de ces faces 8 et 10, par exemple la face 8, aurait été suffisant si l'on avait seulement souhaité appliquer une seule couche métallique (la couche 4 dans cet exemple). De même, il a fallu traiter les faces des couches 4 et 6 destinées à se trouver en regard des faces 8 et 10 de la couche 2. Le traitement des autres faces respectives 12 et 14 des couches 4 et 6 n'est pas nécessaire dans le cas présent.

La figure 2 diffère de la figure 1 par le fait que la couche 4 y est remplacée par une couche métallique 16 faite d'un métal différent du métal qui constitue la couche 6 : cette dernière est par exemple en cuivre et la couche 16 en aluminium.

On va maintenant expliquer comment réaliser un support multicouche, comportant une pluralité de couches de PMP alternant avec des couches métalliques. Ceci est intéressant pour certaines applications dans le domaine des circuits hyperfréquences ou dans d'autres domaines. Les couches métalliques peuvent subir, avant leur assemblage aux couches de PMP, une opération de gravure conforme à une image donnée.

Pour réaliser un tel support multicouche, on réalise une pluralité de supports monocouches (une seule couche de PMP), comme on l'a expliqué plus haut, on grave, s'il le faut, certaines des couches métalliques correspondantes par les techniques classiques de fabrication des circuits imprimés, on superpose ces supports, appelés "supports élémentaires", en interposant entre eux des couches de PMP appelées "couches intermédiaires" et l'on plaque les couches les unes aux autres à l'aide d'un pressage à chaud.

Pour éviter toute déformation des supports élémentaires et plus particulièrement des couches métalliques gravées de ceux-ci, il convient de réaliser ce pressage à une température inférieure à la température de fusion des supports élémentaires.

A cet effet et pour obtenir une bonne adhérence, on utilise pour les couches intermédiaires, un PMP de grade différent de celui qui constitue les supports élémentaires, et plus précisément un PMP dont la température de ramollissement est inférieure à celle du PMP des supports élémentaires, mais qui a les mêmes propriétés électriques.

A titre purement indicatif et nullement limitatif, on utilise le PMP commercialisé par la Socité MITSUI, sous l'appellation TPX, les supports élémentaires sont réalisés en TPX de grade RT 18 (point Vicat 173°C) et pressés à 240°C, les couches intermédiaires sont réalisées en TPX de grade MX 002 (point Vicat 145°C) et l'ensemble des couches est pressé à 235°C.

Pour ce pressage de l'ensemble des couches, il est nécessaire que les traitements préalables des couches de PMP et des couches métalliques que l'on a expliqués plus haut, soient réalisés tant pour les couches métalliques internes que pour les couches intermédiaires de PMP.

Le pressage d'un support multicouche s'effectue avec les mêmes conditions de pression et de refroidissement que pour les supports élémentaires. Seul l'outillage de pressage doit être adapté pour tenir compte de l'épaisseur du support, ou stratifié, final et du centrage des couches.

Les figures 3 à 5 représentent schématiquement des supports comportant plusieurs couches de PMP.

Pour réaliser le support de la figure 3, on réalise un support élémentaire du genre de celui de la figure 1, qui comporte les couches métalliques 4 et 6, et on fixe une autre couche métallique 18 sur la couche 4 par l'intermédiaire d'une couche intermédiaire 20 de PMP.

En fait, dans une variante de réalisation, on peut fixer la couche métallique 18 à la couche métallique 4 par l'intermédiaire de tout autre adhésif approprié.

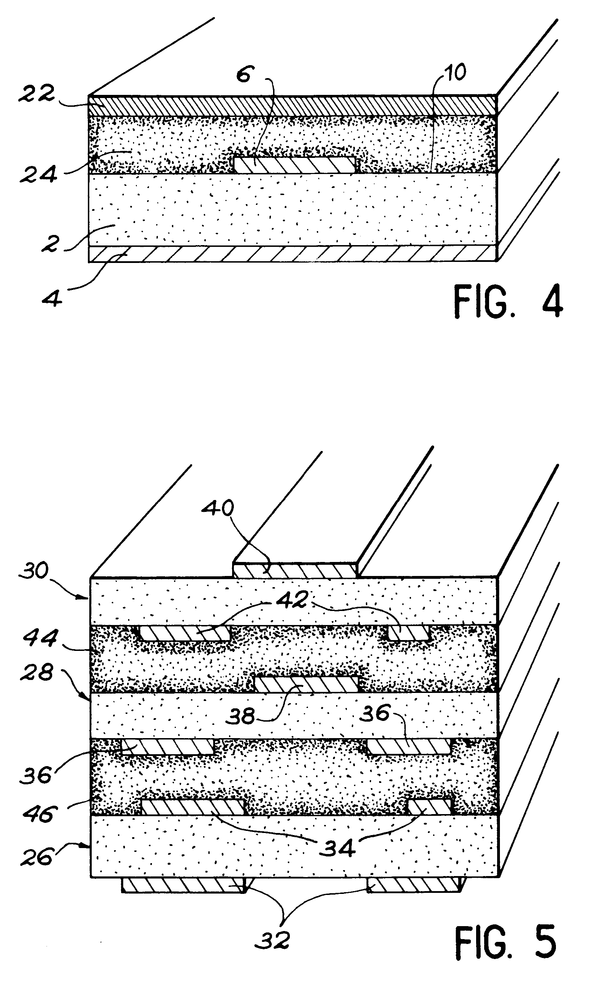

Pour réaliser le support de la figure 4, on utilise encore un support élémentaire du genre de celui de la figure 1 et on fixe une autre couche métallique 22 sur la face 10 de la couche 2, qui porte la couche gravée 6, par l'intermédiaire d'une couche intermédiaire 24 de PMP.

Pour réaliser le support de la figure 5, on réalise trois supports élémentaires 26, 28 et 30 comportant chacun une seule couche de PMP.

Le support 26 porte, sur une face, deux couches métalliques gravées 32 et, sur l'autre face, deux autres couches métalliques gravées 34.

Le support 28 porte, sur une face, deux couches métalliques gravées 36 et, sur l'autre face, une autre couche métallique gravée 38.

Le support 30 porte, sur une face, deux couches métalliques gravées 42 et, sur l'autre face, une couche métallique gravée 40.

Les supports élémentaires 26, 28 et 30 sont fixés les uns aux autres par l'intermédiaire de deux couches intermédiaires 44 et 46 de PMP.

On voit que, dans le support multicouche obtenu, les couches 34, 36, 38 et 42 sont des couches métalliques internes alors que les couches 32 et 40 sont des couches métalliques externes.

Dans certaines réalisations, chacune des couches 24 (figure 4), 44 et 46 (figure 5) peuvent avoir non seulement une fonction d'adhésif mais encore une fonction de diélectrique et ont alors une épaisseur supérieure à 100 micromètres, qui peut aller de quelques centaines de micromètres à plusieurs dizaines de mm.

Dans certains cas, il est souhaitable que les caractéristiques du PMP soient modifiées, pour adapter ses caractéristiques mécaniques et/ou électriques à une application donnée. Ceci doit être effectué de telle sorte que l'on conserve les techniques de réalisation de supports qui ont été précédemment expliquées. On peut y parvenir en ajoutant au PMP diverses charges, notamment des charges minérales.

On a réalisé des supports métallisés conformément au procédé de la présente invention et ces supports ont été soumis à des essais climato-mécaniques normalisés et ont subi ces essais sans dégradation, entre autres l'essai dit "variation rapide de température -65°C +165°C" et l'essai dit "combiné climatique -30°C +125°C, 90% d'humidité relative à 55°C".

## Revendications

1. Procédé de fabrication d'un support métallisé comprenant au moins une couche électriquement isolante dont l'épaisseur est supérieure à 100 micromètres et dont au moins l'une des deux faces est recouverte, au moins partiellement, par une couche métallique, ce procédé comprenant les étapes suivantes :
- on soumet au moins une face (8, 10) d'au moins une couche (2) de poly(méthyl-4 pentène-1), noté PMP, à un traitement de surface capable d'ouvrir des chaînes moléculaires sur ladite face de la couche de PMP,
- on soumet au moins une face d'au moins une couche métallique (4, 6) à une oxydation superficielle capable de favoriser l'adhérence de cette face de la couche métallique à la face traitée de la couche de PMP, et
- on réalise un placage à chaud, à une température au moins égale à la température de fusion du PMP utilisé au niveau des surfaces de contact, de la face traitée de la couche métallique (4, 6) sur la face traitée de la couche (2) de PMP,
l'épaisseur de la couche, dont au moins une face est soumise à un traitement de surface, étant légèrement supérieure à celle que l'on veut obtenir une fois la métallisation terminée,
- on fabrique ledit support en une pluralité d'exemplaires (26, 28, 30), chaque exemplaire comportant une couche de PMP dont l'épaisseur est supérieure à 100 micromètres,
- on superpose les exemplaires ainsi fabriqués en intercalant entre chaque exemplaire et un exemplaire adjacent une couche intermédiaire (44, 46) de PMP dont la température de fusion est inférieure à la température de fusion des couches de PMP des exemplaires fabriqués, la face de chaque couche métallique, destinée à se trouver en regard d'une face d'une couche intermédiaire, étant soumise à ladite oxydation superficielle et cette face de couche intermédiaire étant au préalable soumise au traitement de surface capable d'ouvrir des chaînes moléculaires sur cette face, et
- on réalise un placage à chaud, les uns sur les autres, des exemplaires et des couches intermédiaires, ce placage étant réalisé à une température au moins égale à la température de fusion du PMP des couches intermédiaires et inférieure à la température de fusion des couches de PMP des exemplaires.

2. Procédé selon la revendication 1, caractérisé en ce que le placage des couches est un pressage ou un laminage.

3. Procédé selon l'une quelconque des revendications 1 et 2, caractérisé en ce qu'il comprend en outre une étape de gravure de la couche métallique (6) ainsi plaquée sur la couche (2) de PMP.

4. Procédé selon l'une quelconque des revendications 1 à 3, caractérisé en ce que, le support obtenu comportant au moins une couche métallique externe (4, 6), on fixe en outre, au moyen d'une couche d'adhésif (20, 24), une autre couche métallique (18, 22) à cette couche métallique externe.

5. Procédé selon l'une quelconque des revendications 1 à 4, caractérisé en ce que le traitement de surface de chaque couche de PMP est choisi dans le groupe comprenant l'action d'une solution oxydante, le traitement à la flamme, le traitement par décharge couronne, l'irradiation par un rayonnement ultraviolet et le bombardement électronique.

6. Procédé selon l'une quelconque des revendications 1 à 5, caractérisé en ce que chaque couche métallique (4, 6, 18, 22) est faite d'un métal choisi dans le groupe comprenant le cuivre, les alliages de cuivre, l'aluminium et les alliages d'aluminium.

7. Procédé selon la revendication 6, caractérisé en ce que, la couche métallique étant en aluminium ou en un alliage d'aluminium, l'oxydation superficielle est une oxydation anodique sans colmatage.

8. Procédé selon l'une quelconque des revendications 1 à 7, caractérisé en ce que la face libre de chaque couche métallique externe du support est soumise à une désoxydation après réalisation de ce support.

9. Procédé selon l'une quelconque des revendications 1 à 8, caractérisé en ce que la pression de placage est au moins égale à 10 kg/cm² environ.

10. Procédé selon l'une quelconque des revendications 1 à 9, caractérisé en ce que le poly(méthyl-4 pentène-1) est chargé d'au moins un matériau capable d'en modifier les caractéristiques mécaniques et/ou diélectriques.

## Patentansprüche

1. Verfahren zur Herstellung eines metallisierten Trägers, der mindestens eine elektrisch isolierende Schicht enthält, die stärker ist als 100 Mikrometer, wobei mindestens eine ihrer beiden Flächen zumindest teilweise von einer metallischen Schicht bedeckt ist und dieses Verfahren folgende Etappen umfaßt:
- man unterzieht mindestens eine Fläche (8, 10) von mindestens einer Schicht (2) aus Poly-(Methyl-4-Penten-1), mit PMP bezeichnet, einer Oberflächenbehandlung, durch die die Molekularketten auf der genannten Fläche der Schicht aus PMP geöffnet werden,
- man unterzieht mindestens eine Fläche von mindestens einer metallischen Schicht (4, 6) einer Oberflächenoxidation, wodurch die Haftung dieser Fläche der metallischen Schicht auf der behandelten Fläche der Schicht aus PMP verbessert wird, und
- es wird eine Warmplattierung bei einer Temperatur durchgeführt, die der Schmelztemperatur des PMP entspricht, das für die Kontaktflächen der behandelten Fläche der metallischen Schicht (4, 6) auf der behandelten Fläche der Schicht (2) aus PMP verwendet wird, wobei die Stärke der Schicht, von der mindestens eine Fläche einer Oberflächenbehandlung unterzogen wird, etwas größer ist als die Stärke, die man nach Beendigung der Metallisierung erreichen will,
- der genannte Träger wird in einer Vielzahl von Exemplaren (26, 28, 30) hergestellt, wobei jedes Exemplar eine Schicht aus PMP enthält, die stärker als 100 Mikrometer ist,
- es werden die somit hergestellten Exemplare übereinander gelegt, wobei zwischen jedem Exemplar und dem benachbarten Exemplar eine Zwischenschicht (44, 46) aus PMP eingelagert wird, deren Schmelztemperatur kleiner ist als die Schmelztemperatur der Schichten aus PMP der hergestellten Exemplare, und zwar auf der Oberfläche jeder metallisierten Schicht, die dazu bestimmt ist, sich gegenüber einer Oberfläche einer Zwischenschicht zu befinden, die der genannten Oberflächenoxidation unterzogen wird, wobei diese Oberfläche der Zwischenschicht zuvor der Oberflächenbehandlung unterzogen wurde, durch die die Molekularketten dieser Oberfläche geöffnet werden, und
- es wird eine Warmplattierung zwischen den Exemplaren und den Zwischenschichten durchgeführt, wobei diese Warmplattierung bei einer Temperatur erfolgt, die mindestens so hoch ist wie die Schmelztemperatur des PMP der Zwischenschichten und die kleiner ist als die Schmelztemperatur der PMP-Schichten der Exemplare.

2. Verfahren nach Anspruch 1, dadurch gekennzeichnet, daß die Plattierung der Schichten durch Aufpressen oder Aufwalzen erfolgt.

3. Verfahren nach einem der Ansprüche 1 und 2, dadurch gekennzeichnet, daß es unter anderem eine Gravur der metallischen Schicht (6) beinhaltet, die auf diese Weise auf die Schicht (2) aus PMP aufgebracht wurde.

4. Verfahren nach einem der Ansprüche 1 bis 3, dadurch gekennzeichnet, daß man unter anderem ausgehend von dem erhaltenen Träger, der mindestens eine externe metallische Schicht (4, 6) aufweist, mit Hilfe einer Haftmittelschicht (20, 24) auf diese äußere metallische Schicht eine weitere metallische Schicht (18, 22) aufbringt.

5. Verfahren nach einem der Ansprüche 1 bis 4, dadurch gekennzeichnet, daß die Oberflächenbehandlung jeder PMP-Schicht entsprechend einer Klasse von Behandlungsarten erfolgt, die den Einsatz einer Oxidationslösung, die Behandlung durch eine Flamme, die Behandlung durch eine Koronaentladung, die Bestrahlung durch ultraviolette Strahlen und den Elektronenbeschuß beinhaltet.

6. Verfahren nach einem der Ansprüche 1 bis 5, dadurch gekennzeichnet, daß jede der metallischen Schichten (4, 6, 18, 22) aus einem Metall besteht, daß Bestandteil der Klasse ist, die Kupfer, Kupferlegierungen, Aluminium und Aluminiumlegierungen enthält.

7. Verfahren nach Anspruch 6, dadurch gekennzeichnet, daß ausgehend davon, daß die metallische Schicht aus Aluminium oder aus einer Aluminiumlegierung besteht, die Oberflächenoxidation durch eine anodische Oxidation ohne Ablagerung erfolgt.

8. Verfahren nach einem der Ansprüche 1 bis 7, dadurch gekennzeichnet, daß die freie Fläche jeder äußeren metallischen Schicht des Trägers nach Herstellung dieses Trägers einer Desoxidation unterzogen wird.

9. Verfahren nach einem der Ansprüche 1 bis 8, dadurch gekennzeichnet, daß der Plattierungsdruck mindestens etwa 10 kg/cm² entspricht.

10. Verfahren nach einem der Ansprüche 1 bis 9, dadurch gekennzeichnet, daß das Poly-(Methyl-4-Penten-1) mit mindestens einem Werkstoff dotiert ist, der die mechanischen und/oder dielektrischen Eigenschaften dieses Stoffes verändern kann.

## Claims

1. Process for the manufacture of a metallized substrate comprising at least one electrically insulating layer whose thickness is greater than 100 micrometres and at least one of whose two faces is covered, at least partially, by a metallic layer, this process comprising the following steps:
- at least one face (8, 10) having at least one layer (2) of poly(methyl-4 pentene-1), denoted PMP, is subjected to a surface treatment capable of opening molecular chains of said face of the PMP layer,
- at least one face having at least one metallic layer (4, 6) is subjected to surface oxidation capable of encouraging this face of the metallic layer to adhere to the treated face of the PMP layer, and
- hot plating is carried out, at a temperature at least equal to the melting point of the PMP used on the contact surfaces, of the treated face of the metallic layer (4, 6), on the treated face of the PMP layer (2), the thickness of the layer, at least one face of which is subjected to a surface treatment, being slightly greater than that which is required for the finished metallization,
- said substrate is manufactured in several sections (26, 28, 30), each section containing a layer of PMP, the thickness of which is- greater than 100 micrometres,
- the sections thus manufactured are superimposed by interposing between each section and an adjacent section an intermediate layer (44, 46) of PMP, the melting point of which is less than the melting point of the layers of PMP of the manufactured sections, the face of each metallic layer arranged to face one face of an intermediate layer being subjected to said surface oxidation, and this face of the intermediate layer being previously subject to the surface treatment capable of opening molecular chains on this face, and
- hot plating is carried out of the sections, one of top of the other, and of the intermediate layers, this plating being carried out at a temperature at least equal to the melting point of the PMP of the intermediate layers and below the melting point of the PMP layers of the sections.

2. Process according to Claim 1, **characterised in that** the plating of the layers is a pressing or a lamination.

3. Process according to any one of Claims 1 and 2, **characterised in that** it further comprises an etching step for the metallic layer (6) thus plated onto the layer (2) of the PMP.

4. Process according to any one of Claims 1 to 3, **characterised in that** the substrate thus obtained comprises at least one external metallic layer (4, 6) and furthermore, another metallic layer (18, 22) is attached to this external metallic layer by means of an adhesive layer (20, 24).

5. Process according to any one of Claims 1 to 4, **characterised in that** the surface treatment of each PMP layer is selected from the group comprising the action of an oxidizing solution, flame treatment, corona discharge treatment, irradiation by ultra violet radiation and electronic bombardment.

6. Process according to any one of Claims 1 to 5, **characterised in that** each metallic layer (4, 6, 18, 22) is made of a metal selected from the group comprising copper, alloys of copper, aluminium and alloys of aluminium.

7. Process according to Claims 6, **characterised in that** the metallic layer being of aluminium or of an alloy of aluminium, the surface oxidation is anodic oxidation without sealing.

8. Process according to any one of Claims 1 to 7, **characterised in that** the exposed external face of each metallic layer of the substrate is subjected to deoxidation after completion of the substrate.

9. Process according to any one of Claims 1 to 8, **characterised in that** the plating pressure is at least approximately 10 kg/cm².

10. Process according to any one of Claims 1 to 9, **characterised in that** the poly(methyl-4 pentene-1) is loaded with at least one material capable of modifying the mechanical and/or dielectric characteristics.
